(19) Europäisches Patentamt
European Patent Office
Office européen des brevets

(11) **EP 1 767 400 B1**

(12) **EUROPÄISCHE PATENTSCHRIFT**

(45) Veröffentlichungstag und Bekanntmachung des Hinweises auf die Patenterteilung:
**13.06.2012 Patentblatt 2012/24**

(21) Anmeldenummer: **06019298.6**

(22) Anmeldetag: **15.09.2006**

(51) Int Cl.:
*H01H 25/04* (2006.01)     *G01D 5/00* (2006.01)
*H03K 17/975* (2006.01)

(54) **Vorrichtung zur Erfassung von Schaltstellungen eines Schaltmittels**

Device for acquiring the position of a switching mean

Dispositif de détermination de la position d'un intérupteur

(84) Benannte Vertragsstaaten:
**DE FR IT**

(30) Priorität: **27.09.2005 DE 102005046099**

(43) Veröffentlichungstag der Anmeldung:
**28.03.2007 Patentblatt 2007/13**

(73) Patentinhaber: **Valeo Schalter und Sensoren GmbH**
**74321 Bietigheim-Bissingen (DE)**

(72) Erfinder: **Ullmann, Tim**
**74376 Gemmrigheim (DE)**

(74) Vertreter: **Pothmann, Karsten**
**Valeo Schalter und Sensoren GmbH**
**74319 Bietigheim-Bissingen (DE)**

(56) Entgegenhaltungen:
**EP-A- 0 628 976      EP-B1- 0 891 266**
**DE-A1- 2 737 110      DE-C1- 19 808 665**
**US-A- 4 305 007      US-A- 5 479 191**
**US-A- 5 914 704**

## Beschreibung

Die Erfindung betrifft eine Vorrichtung zur Erfassung von Schaltstellungen eines Schaltmittels eines Lenkstockschalters eines Kraftfahrzeugs.

Es ist aus dem Stand der Technik bekannt, die Schaltstellungen mit Hilfe von elektrischen Schleifkontakten zu erfassen. Dies hat den Nachteil, dass sich die mechanischen Kontakte während der Betriebsdauer des Lenkstockschalters abnutzen können und somit eine zuverlässige Detektion von Schaltstellungen nicht mehr gewährleistet ist.

Die US 4 305 007 betrifft einen Kontrollhebel, um Steuerbewegungen in zwei Raumrichtungen stufenlos zu erfassen. Der Kontrollhebel umfasst ein mit dem Bedienabschnitt bewegungsgekoppeltes Bauteil, das zwischen einem Paar plattenförmiger Ladungsträger, um Bewegungen des Kontrollhebels in einer ersten Raumrichtung zur erfassen, sowie einem zweiten Paar von Ladungsträgern angeordnet ist, um Bewegungen des Kontrollhebels in einer zweiten Bewegungsrichtung zur erfassen. Um die Position des Bedienteils zu erfassen, werden dabei jeweils die Kapazitäten zwischen dem geerdeten Bauteil und den Ladungsträgern gemessen.

Aus der US 5 479 191 ist eine Vorrichtung zur stufenlosen Eingabe von Koordinaten über einen Drehregler bekannt. Der Drehregler ist mit einem Bauteil gekoppelt, dass zwischen einem durchgehenden oberen Ladungsträger und vier unteren Ladungsträgersegmenten angeordnet ist. Der bekannte Drehregler ist zur kontinuierlichen Erfassung von Drehstellungen des Bauteils ausgebildet.

Aus der DE 298 17 668 U1 und aus der DE 102 12 824 A1 ist es bekannt, die Erfassung von Schaltstellungen eines Lenkstockschalters durch optikelektronische Mittel zu bewirken. Hierbei ist die Bewegung des Lenkstockschalters beispielsweise mit einer Blende gekoppelt, die in bestimmten Stellungen des Lenkstockschalters einen Durchtritt von Licht von einem Sende- zu einem Empfangselement erlaubt. Zwar kann mit Hilfe der optikelektronischen Mitteln der Verschleiß gegenüber den mechanischen Schleifkontakten verringert werden, dennoch kann es vorkommen, dass beispielsweise durch Verschmutzung des Sende- oder Empfangselements eine zuverlässige Erfassung eines Lichtsignals und die damit verbundene Detektion einer Schaltstellung eines Schaltmittels nicht immer gewährleistet ist.

Hiervon ausgehend liegt der vorliegenden Erfindung die Aufgabe zugrunde, eine möglichst betriebssichere, verschleißfreie Vorrichtung zur Erfassung von Schaltstellungen eines Schaltmittels zu schaffen.

Diese Aufgabe wird erfindungsgemäß dadurch gelöst, dass die Vorrichtung mindestens zwei elektrische Ladungsträger zum Aufbau eines elektrischen Feldes aufweist, wobei in dem elektrischen Feld ein Bauteil angeordnet ist, das zumindest mittelbar mit der Bewegung des Schaltmittels gekoppelt ist.

Die erfindungsgemäße Vorrichtung beruht darauf, die Schaltstellung eines Schaltmittels kapazitiv erfassen zu können. Dies hat den Vorteil, dass weder mechanische Kontaktstellen noch optische Sende- oder Empfangselemente verwendet werden müssen. Durch die Anordnung des Bauteils in einem elektrischen Feld kann eine berührungslose und schmutzunempfindliche Anordnung geschaffen werden.

Das Bauteil kann durch einen Abschnitt des Schaltmittels gebildet sein, wodurch die Bauteilzahl reduziert wird und die Vorrichtung besonders kompakt baut.

Das Bauteil kann auch durch ein mit dem Schaltmittel bewegungsgekoppeltes Zusatzelement gebildet sein. Dies hat den Vorteil, dass die erfindungsgemäße Vorrichtung mit den Ladungsträgern räumlich vom Schaltmittel entfernt angeordnet sein kann.

Das Bauteil kann drehbar und/oder axial verschiebbar sein. Wenn das Bauteil drehbar ist, können verschiedene Drehstellungen eines Schaltmittels erfasst werden. Wenn das Bauteil axial verschiebbar ist, können Schaltstellungen entlang einer Verschiebeachse detektiert werden.

In vorteilhafter Weise sind die Ladungsträger plattenförmig ausgebildet, wodurch nur wenig Bauraum benötigt wird.

Die Ladungsträger können in einer Ebene angeordnet sein, so dass sich jeweils zwischen zwei Ladungsträgern ein elektrisches Feld aufbauen kann, dessen Feldstärke je nach Abstand des Bauteils zu den Ladungsträgern variiert. Dies ist auch möglich, wenn die Ladungsträger winklig, insbesondere senkrecht zueinander angeordnet sind.

Die Erfindung sieht vor, dass mindestens vier Ladungsträger, insbesondere acht Ladungsträger vorgesehen sind, die das Bauteil, eine Rahmenstruktur bildend, umgeben. Jeweils zwei der Ladungsträger erzeugen ein elektrisches Feld, so dass insgesamt zwei beziehungsweise vier elektrische Felder erzeugt werden, die jeweils lokal unterschiedliche Feldstärken haben und die auch für sich unterschiedlich orientiert sind. Dies hat den Vorteil, dass die Auflösung, mit der die Schaltstellung des Bauteils detektiert werden kann, zunimmt.

Wenn mehrere, zueinander parallele Rahmenstrukturen vorgesehen sind, kann eine Erfassung der Drehstellung des Bauteils in verschiedenen Ebenen erfolgen, so dass eine Vielzahl von Schaltstellungen detektiert werden kann.

Der Rahmen kann eine Abschirmung aufweisen, um einerseits die erfindungsgemäße Vorrichtung vor elektrischen Einflüssen von außen zu schützen und um andererseits die Umgebung der Vorrichtung von den elektrischen Feldern der erfindungsgemäßen Vorrichtung entkoppeln zu können.

Das Bauteil kann stößelartig ausgebildet sein, wodurch es besonders klein baut und gut in einer von Ladungsträgern gebildeten Rahmenstruktur aufnehmbar ist.

Das Bauteil kann zur Veränderung des elektrischen Feldes auch geometrische Kodierungselemente aufweisen. Das Bauteil kann also einen von einem zylindrischen Querschnitt abweichenden Querschnitt aufweisen. Beispielsweise kann das Bauteil im Querschnitt T-förmig sein.

Das Bauteil kann Materialien mit dielektrischen Eigenschaften aufweisen, bspw. Kunststoff oder Keramik. Entsprechende Materialabschnitte können auch durch ein Zusatzteil gebildet sein, das mit dem Bauteil verbunden wird, bspw. durch Aufschieben oder Ummanteln.

Wenn die Vorrichtung Rastmittel zur Zwangsführung des Schaltmittels aufweist, kann einer Bedienperson des Schaltmittels eine haptische Rückmeldung darüber gegeben werden, dass eine bestimmte Schaltstellung erreicht ist.

In vorteilhafter Weise weist die Vorrichtung eine Kapselung auf, um ein Trägermaterial für die Ladungsträger zu schaffen. Weiterhin ist es vorteilhaft, wenn die Außenfläche der Kapselung einem am oder im Schaltmittel gebildeten Aufnahmeraum angepasst ist. Die erfindungsgemäße Vorrichtung kann dann modulartig verwendet werden und in den Aufnahmeraum eines Schaltmittels eingesetzt werden.

In vorteilhafter Weise umfasst die Vorrichtung eine mit den Ladungsträgern in Verbindung stehende Ansteuer- und/oder Auswerteeinheit. Mit Hilfe der Ansteuereinheit kann die Ladungsmenge der Ladungsträger bestimmt werden. Mit Hilfe der Auswerteeinheit kann die Veränderung der Ladungsmenge durch die Veränderung des elektrischen Feldes aufgrund der Bewegung des Bauteils erfasst werden.

Die Auswertung der von den Ladungsträgern erzeugten elektrischen Signale kann auf Basis konkreter oder digitalisierter Spannungswerte erfolgen. Bei Auswertung auf Basis konkreter Spannungswerte können Schaltstellungen stufenlos erfasst werden; bei Auswertung auf Basis digitalisierter Spannungswerte kann eine besonders einfache Auswertung von gestuften Schaltstellungen erfolgen.

Zusätzlich zu den oben beschriebenen Ansteuer- und/oder Auswerteeinheiten können auch kapazitätssensitive IC-Elemente verwendet werden. Solche Elemente werden beispielsweise unter der Bezeichnung "MC33794 E-field IC" von Motorola oder "Eval-AD7745/AD7746EB" von Analog Devices vertrieben. Diese

Elemente steuern Elektroden, die ein elektrisches Feld erzeugen, nacheinander an. Die Auswertung erfolgt durch einen Mikrocontroller. Durch Annäherung oder Entfernung eines Dielektrikums, das mit dem Schaltmittel bewegungsgekoppelt ist, wird die jeweilige Feldstärke verändert. Es ist vorteilhaft, die Elektroden einzeln anzusteuern und auszuwerten, um Störeinflüsse aufgrund der anderen Elektroden zu verhindern.

Nachfolgend werden besonders bevorzugte Ausführungsbeispiele der vorliegenden Erfindung unter Bezugnahme auf die beiliegenden Zeichnungen näher erläutert.

Es zeigen:

| | |
|---|---|
| Figur 1 | eine schematische Darstellung einer erfindungsgemäßen Vorrichtung gemäß einer ersten Ausführungsform; |
| Figur 2 | eine schematische Darstellung einer erfindungsgemäßen Vorrichtung gemäß einer zweiten Ausführungsform; |
| Figur 3 | eine schematische, perspektivische Ansicht der Vorrichtung gemäß Figur 2; |
| Figuren 4 und 5 | weitere Anordnungsmöglichkeiten von Ladungsträgern einer erfindungsgemäßen Vorrichtung; und |
| Figur 6 | eine weitere Ausführungsform der Erfindung. |

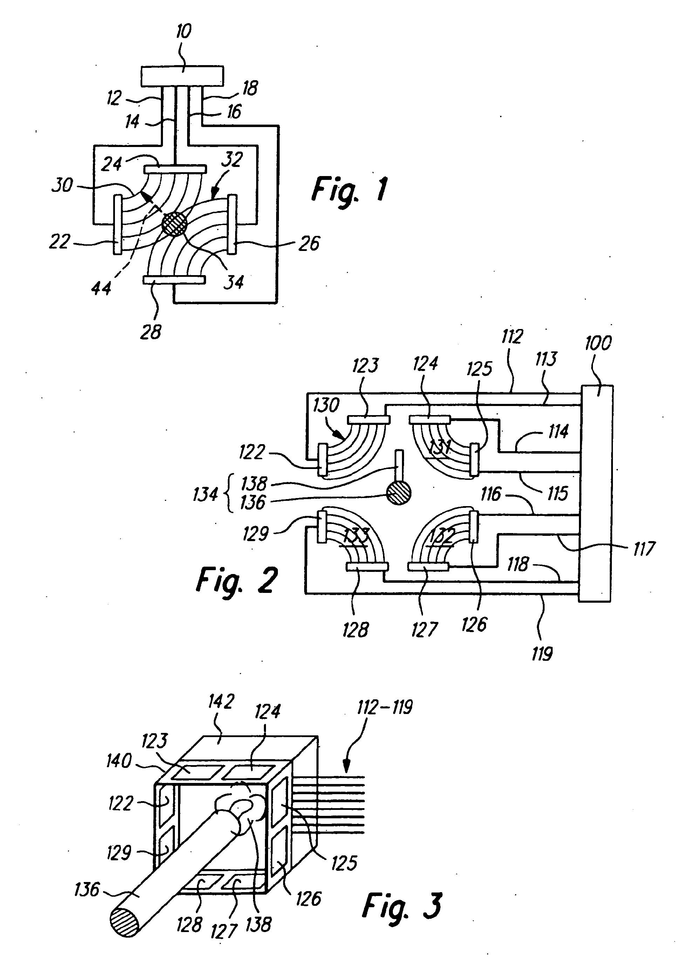

In Figur 1 ist eine Ansteuer- und Auswerteeinheit 10 dargestellt, die über Leitungen 12, 14, 16 und 18 mit zugeordneten Ladungsträgern 22, 24, 26 und 28 verbunden ist. Die Ladungsträger 22 bis 28 sind plattenförmig ausgebildet und begrenzen einen quaderförmigen Raum.

Zwischen den Ladungsträgern 22 und 24 ist durch Anlegen einer Spannung ein elektrisches Feld 30 aufgebaut, welches in Figur 1 mit gekrümmten Feldlinien angedeutet ist. Entsprechend ist zwischen den Ladungsträgern 26 und 28 ein elektrisches Feld 32 aufgebaut.

In dem von den Ladungsträgern 22 bis 28 begrenzten Raum ist ein Bauteil 34 angeordnet, das mit der Bewegung eines nicht dargestellten Schaltmittels gekoppelt ist.

Figur 2 zeigt eine der in Figur 1 dargestellten Vorrichtung ähnliche Vorrichtung, die auch eine Ansteuer- und Auswerteeinheit 100 aufweist. Diese ist über Leitungen 112 bis 119 mit Ladungsträgern 122 bis 129 verbunden. Es sind jeweils zwei Ladungsträger, die plattenförmig aufgebaut sind, senkrecht zueinander angeordnet, so die Ladungsträger 122 und 123, 124 und 125, 126 und 127, und 128 und 129. Die letztgenannten Paare bilden elektrische Felder 130 bis 133.

Die Ladungsträger 122 bis 129 bilden eine Rahmenstruktur, innerhalb derer ein Bauteil 134 aufgenommen ist. Das Bauteil 134 weist einen zylindrischen, im Querschnitt dargestellten Abschnitt 136 und eine Materialerweiterung auf, die eine geometrische Kodierung 138 bildet.

In Figur 3 ist die Vorrichtung gemäß Figur 2 perspektivisch dargestellt. Die Ladungsträger 122 bis 129 sind auf einem insgesamt quadratischen Rahmenelement 140 angeordnet. Dieses ist mit einer nur schematisch und nur abschnittsweise dargestellten Kapselung 142 verbunden, welche die Rahmenstruktur 140 umgibt.

Die Schaltstellungen eines Schaltmittels können folgendermaßen detektiert werden. Bspw. wird bei Bewegung des Schaltmittels das Bauteil 34 relativ zu den elektrischen Feldern 30 und 32 bewegt. Das Bauteil 34 hat dielektrische Eigenschaften, wodurch bei Bewegung des Bauteils 34 in eine andere Position die elektrischen Felder 30 und 32 geändert werden. Hierdurch wird die Kapazität C eines Paares von Ladungsträgern, bspw. der Ladungsträger 22 und 24 in einer Richtung verändert (bspw. erhöht) und die Kapazität C eines anderen Paares von Ladungsträgern, bspw. der Ladungsträger 26 und 28 in einer anderen Richtung verändert (bspw. gesenkt). Wenn das Bauteil sich also in der in Figur 1 mit dem Bezugszeichen 44 bezeichneten Richtung bewegt, wird die Kapazität des Paares von Ladungsträgern 22 und 24 erhöht, während die Kapazität des Paares von Ladungsträgern 26 und 28 gesenkt wird.

Die Ladungsmenge Q eines Paares von Ladungsträgern bestimmt sich aus dem Produkt aus Kapazität C und angelegter Spannung U. Verändert sich nun die Kapazität C eines Paares von Ladungsträgern (bspw. 22 und 24), fließt in den zugeordneten Leitungen (bspw. 12 und 14) ein Strom, der von der Auswerteeinheit 10 detektiert werden kann. Die Stärke des Stroms ist ein Maß für die Änderung der Kapazität C eines Paares von Ladungsträgern und somit ein Maß für die Bewegung des Bauteils 34 bzw. des damit gekoppelten Schaltmittels.

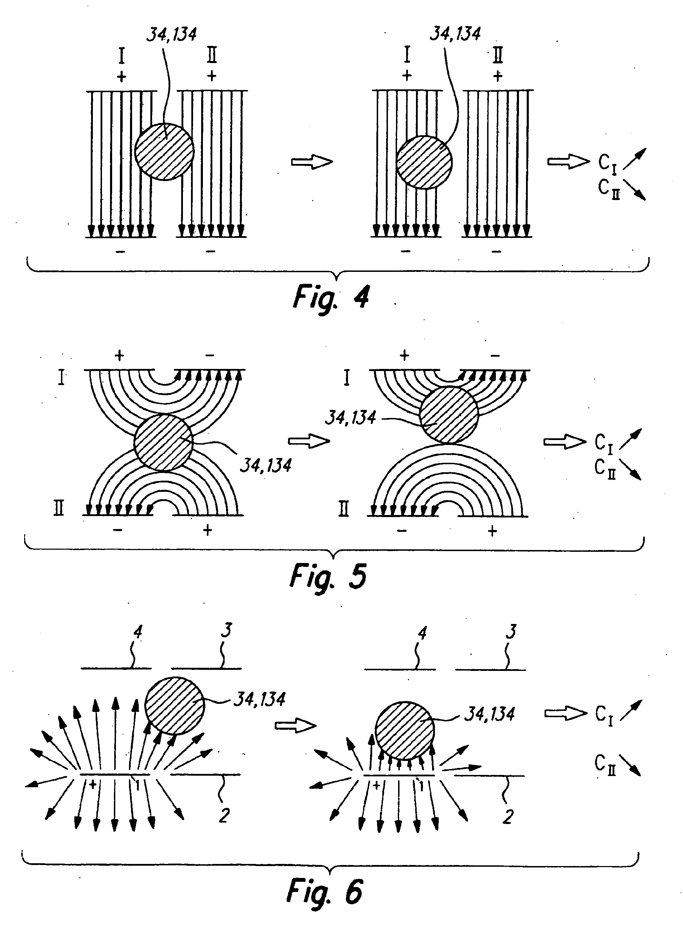

Die Ladungsträger eines Paares können auch parallel zueinander angeordnet sein, wie in Figur 4 dargestellt. Dort trägt ein erstes Paar von zueinander parallelen, entgegengesetzt geladenen Ladungsträgern das Bezugszeichen

I, ein zweites Paar das Bezugszeichen II. Die Kapazität C eines Paares von Ladungsträger.ergibt aus

$$C = \frac{\varepsilon_0 * \varepsilon_r * A}{d}$$

Dabei ist

$\varepsilon_0$ = elektrische Feldkonstante,
$\varepsilon_r$ = Dielektrizitätszahl des zwischen den Ladungsträgern befindlichen Dielektrikums (dieses bestimmt sich durch die dielektrischen Eigenschaften des zwischen den Ladungsträgern vorhandenen Gases (bspw. Luft) und des zwischen die Ladungsträger ragenden Bauteils 34)
A = Fläche eines Ladungsträgers, und
d = Abstand der beiden Ladungsträger.

Wird das Bauteil 34 oder 134 aus der in Figur 4 linkerhand dargestellten Lage in die in Figur 4 rechterhand dargestellte Lage gebracht, erhöht sich die Kapazität $C_I$ der Ladungsträger I, während die Kapazität $C_{II}$ der Ladungsträger II sinkt.

Die Ladungsträger eines Paares können auch miteinander fluchtend angeordnet sein, wie in Figur 5 dargestellt. Dort trägt ein erstes Paar von miteinander fluchtenden, entgegengesetzt geladenen Ladungsträgern das Bezugszeichen I, ein zweites Paar das Bezugszeichen II. Wird das Bauteil 34 oder 134 aus der in Figur 5 linkerhand dargestellten Lage in die in Figur 5 rechterhand dargestellte Lage gebracht, erhöht sich die Kapazität $C_I$ der Ladungsträger I, während die Kapazität $C_{II}$ der Ladungsträger II sinkt.

Anstelle von Ladungsträgern können auch kapazitätssensitive IC-Elemente verwendet werden, deren Elektroden in Figur 6 symbolisch dargestellt und mit Bezugszeichen 1 bis 4 versehen sind. Dabei erhöht bei der Bewegung eines dielektrischen Bauteils 34 oder 134 aus der in Figur 6 linkerhand dargestellten Lage in die in Figur 5 rechterhand dargestellte Lage die Kapazität der Elektrode 1. Dabei sinkt die Kapazität einer kurze Zeit später angesteuerten Elektrode 2.

## Patentansprüche

**1.** Lenkstockschalter mit einer Vorrichtung zur Erfassung von Schaltstellungen eines Schaltmittels des Lenkstockschalters eines Kraftfahrzeugs, **dadurch gekennzeichnet, dass** die Vorrichtung mindestens zwei elektrische Ladungsträger (22 bis 28, 122 bis 129) zum Aufbau eines elektrischen Feldes (30, 32, 130 bis 133) aufweist, wobei in dem elektrischen Feld ein Bauteil (34, 134) angeordnet ist, das zumindest mittelbar mit der Bewegung des Schaltmittels gekoppelt ist, wobei zur Detektion der Schaltstellungen des Schaltmittels mindestens vier (22 bis 28) Ladungsträger vorgesehen sind, wobei jeweils zwischen zwei Ladungsträgern (22, 24 bzw. 26, 28) ein elektrisches Feld (30 bzw. 32) aufgebaut ist und wobei das Schaltmittel, das Bauteil (34, 134) und die Ladungsträger (22, 24 bzw. 26, 28) so ausgebildet sind, dass bei Bewegung des Bauteils (34) in eine andere Position die elektrischen Felder (30, 32) geändert werden, derart dass die Kapazität eines Paares von Ladungsträgern (22, 24) erhöht und die Kapazität eines anderen Paares von Ladungsträgern (26, 28) gesenkt wird.

**2.** Lenkstockschalter nach Anspruch 1, **dadurch gekennzeichnet, dass** das Bauteil (34, 134) durch einen Abschnitt des Schaltmittels gebildet ist.

**3.** Lenkstockschalter nach Anspruch 1, **dadurch gekennzeichnet, dass** das Bauteil (34, 134) durch ein mit dem Schaltmittel bewegungsgekoppeltes Zusatzelement gebildet ist.

**4.** Lenkstockschalter nach mindestens einem der vorhergehenden Ansprüche, **dadurch gekennzeichnet, dass** das Bauteil (34, 134) drehbar und/oder axial verschiebbar ist.

5. Lenkstockschalter nach mindestens einem der vorhergehenden Ansprüche, **dadurch gekennzeichnet, dass** die Ladungsträger (22 bis 28, 122 bis 129) plattenförmig ausgebildet sind.

6. Lenkstockschalter nach mindestens einem der vorhergehenden Ansprüche, **dadurch gekennzeichnet, dass** die Ladungsträger (22 bis 28, 122 bis 129) in einer Ebene angeordnet sind.

7. Lenkstockschalter nach mindestens einem der vorhergehenden Ansprüche, **dadurch gekennzeichnet, dass** die Ladungsträger (22 bis 28, 122 bis 129) winklig, insbesondere senkrecht zueinander angeordnet sind.

8. Lenkstockschalter nach mindestens einem der vorhergehenden Ansprüche, **dadurch gekennzeichnet, dass** acht Ladungsträger (122 bis 129) vorgesehen sind, die das Bauteil (34, 134), eine Rahmenstruktur bildend, umgeben.

9. Lenkstockschalter nach Anspruch 8, **dadurch gekennzeichnet, dass** mehrere, zueinander parallele Rahmenstrukturen vorgesehen sind.

10. Lenkstockschalter nach Anspruch 8 oder 9, **dadurch gekennzeichnet, dass** die Rahmenstruktur eine Abschirmung aufweist.

11. Lenkstockschalter nach mindestens einem der vorhergehenden Ansprüche, **dadurch gekennzeichnet, dass** das Bauteil (34, 134) stößelartig ausgebildet ist.

12. Lenkstockschalter nach mindestens einem der vorhergehenden Ansprüche, **dadurch gekennzeichnet, dass** das Bauteil (34, 134) zur Veränderung des elektrischen Feldes (30, 32, 130 bis 133) geometrische Kodierungselemente (138) aufweist, welche jeweils durch eine Materialerweiterung gebildet sind.

13. Lenkstockschalter nach mindestens einem der vorhergehenden Ansprüche, **dadurch gekennzeichnet, dass** das Bauteil (34, 134) zumindest abschnittsweise magnetisches oder magnetisierbares Material aufweist.

14. Lenkstockschalter nach mindestens einem der vorhergehenden Ansprüche, **dadurch gekennzeichnet, dass** die Vorrichtung Rastmittel zur Zwangsführung des Schaltmittels aufweist.

15. Lenkstockschalter nach mindestens einem der vorhergehenden Ansprüche, **dadurch gekennzeichnet, dass** die Vorrichtung eine Kapselung (142) aufweist.

16. Lenkstockschalter nach Anspruch 15, **dadurch gekennzeichnet, dass** die Außenfläche der Kapselung einem am oder im Schaltmittel gebildeten Aufnahmeraum angepasst ist.

17. Lenkstockschalter nach mindestens einem der vorhergehenden Ansprüche, **dadurch gekennzeichnet, dass** die Vorrichtung eine mit den Ladungsträgern (22 bis 28, 122 bis 129) in Verbindung stehende Ansteuer- und/oder Auswerteeinheit (10, 110) umfasst.

18. Lenkstockschalter nach mindestens einem der vorhergehenden Ansprüche, **dadurch gekennzeichnet, dass** die Auswertung der von den Ladungsträgern (22 bis 28, 122 bis 129) erzeugten elektrischen Signale auf Basis konkreter Spannungswerte erfolgt.

19. Lenkstockschalter nach mindestens einem der Ansprüche 1 bis 17, **dadurch gekennzeichnet, dass** die Auswertung der von den Ladungsträgern (22 bis 28, 122 bis 129) erzeugten elektrischen Signale auf Basis digitalisierter Spannungswerte erfolgt.

20. Lenkstockschalter nach mindestens einem der vorhergehenden Ansprüche, **dadurch gekennzeichnet, dass** die Vorrichtung zusätzlich kapazitätssensitive IC-Elemente aufweist.

**Claims**

1. Steering column switch having a device for acquiring switched positions of a switching means of the steering column switch of a motor vehicle, **characterized in that** the device has at least two electrical charge carriers (22 to 28, 122 to 129) for establishing an electrical field (30, 32, 130 to 133), wherein a component (34, 134) which is coupled at least indirectly to the movement of the switching means is arranged in the electrical field, wherein at least four (22 to 28) charge carriers are provided for detecting the switched positions of the switching means, wherein in each case one electrical field (30 or 32) is established between two charge carriers (22, 24 and 26, 28, respectively), and wherein the switching means, the component (34, 134) and the charge carriers (22, 24 and 26, 28, respectively) are constructed in such a way that when the component (34) moves into another position the electrical fields (30, 32) are changed in such a way that the capacitance of one pair of charge carriers (22, 24) is increased, and the capacitance of another pair of charge carriers (26, 28) is reduced.

2. Steering column switch according to Claim 1, **characterized in that** the component (34, 134) is formed by a section of the switching means.

3. Steering column switch according to Claim 1, **characterized in that** the component (34, 134) is formed by an additional element which is coupled in terms of movement to the switching means.

4. Steering column switch according to at least one of the preceding claims, **characterized in that** the component (34, 134) is rotatable and/or axially displaceable.

5. Steering column switch according to at least one of the preceding claims, **characterized in that** the charge carriers (22 to 28, 122 to 129) are embodied in a plate shape.

6. Steering column switch according to at least one of the preceding claims, **characterized in that** the charge carriers (22 to 28, 122 to 129) are arranged in a plane.

7. Steering column switch according to at least one of the preceding claims, **characterized in that** the charge carriers (22 to 28, 122 to 129) are arranged at an angle, in particular perpendicularly with respect to one another.

8. Steering column switch according to at least one of the preceding claims, **characterized in that** eight charge carriers (122 to 129) are provided which surround the component (34, 134) so as to form a frame structure.

9. Steering column switch according to Claim 8, **characterized in that** a plurality of frame structures which are parallel to one another are provided.

10. Steering column switch according to Claim 8 or 9, **characterized in that** the frame structure has a screen.

11. Steering column switch according to at least one of the preceding claims, **characterized in that** the component (34, 134) is embodied in the manner of a plunger.

12. Steering column switch according to at least one of the preceding claims, **characterized in that** the component (34, 134) has geometric encoding elements (138) for changing the electrical field (30, 32, 130 to 133), which encoding elements (138) are respectively formed by a widened portion of material.

13. Steering column switch according to at least one of the preceding claims, **characterized in that** the component (34, 134) has, at least in certain sections, magnetic or magnetizable material.

14. Steering column switch according to at least one of the preceding claims, **characterized in that** the device has latching means for positively guiding the switching means.

15. Steering column switch according to at least one of the preceding claims, **characterized in that** the device has an encapsulation (142).

16. Steering column switch according to Claim 15, **characterized in that** the outer surface of the encapsulation is adapted to a receptacle space which is formed on or in the switching means.

17. Steering column switch according to at least one of the preceding claims, **characterized in that** the device comprises an actuation and/or evaluation unit (10, 110) which is connected to the charge carriers (22 to 28, 122 to 129).

18. Steering column switch according to at least one of the preceding claims, **characterized in that** the evaluation of the electrical signals which are generated by the charge carriers (22 to 28, 122 to 129) takes place on the basis of specific voltage values.

19. Steering column switch according to at least one of Claims 1 to 17, **characterized in that** the evaluation of the electrical signals which are generated by the charge carriers (22 to 28, 122 to 129) takes place on the basis of digitized voltage values.

20. Steering column switch according to at least one of the preceding claims, **characterized in that** the device additionally has capacitance-sensitive IC elements.

## Revendications

1. Commutateur de colonne de direction comprenant un dispositif pour détecter les positions de commutation d'un moyen de commutation du commutateur de colonne de direction d'un véhicule automobile, **caractérisé en ce que** le dispositif présente au moins deux porteurs de charges électriques (22 à 28, 122 à 129) pour établir un champ électrique (30, 32, 130 à 133), un composant (34, 134) qui est couplé au moins indirectement avec le mouvement du moyen de commutation étant disposé dans le champ électrique, au moins quatre porteurs de charges (22 à 28) étant prévus pour détecter les positions de commutation du moyen de commutation, un champ électrique (30 ou 32) étant à chaque fois établi entre deux porteurs de charges (22, 24 ou 26, 28) et le moyen de commutation, le composant (34, 134) et les porteurs de charges (22, 24 ou 26, 28) étant configurés de telle manière qu'un mouvement du composant (34) dans une autre position entraîne une modification des champs électriques (30, 32) de telle sorte que la capacité d'une paire de porteurs de charges (22, 24) est accrue et la capacité d'une autre paire de porteurs de charges (26, 28) est réduite.

2. Commutateur de colonne de direction selon la revendication 1, **caractérisé en ce que** le composant (34, 134) est formé par une portion du moyen de commutation.

3. Commutateur de colonne de direction selon la revendication 1, **caractérisé en ce que** le composant (34, 134) est formé par un élément complémentaire couplé en mobilité avec le moyen de commutation.

4. Commutateur de colonne de direction selon au moins l'une des revendications précédentes, **caractérisé en ce que** le composant (34, 134) est rotatif et/ou peut être déplacé dans le sens axial.

5. Commutateur de colonne de direction selon au moins l'une revendications précédentes, **caractérisé en ce que** les porteurs de charges (22 à 28, 122 à 129) sont réalisés en forme de plaques.

6. Commutateur de colonne de direction selon au moins l'une des revendications précédentes, **caractérisé en ce que** les porteurs de charges (22 à 28, 122 à 129) sont disposés dans un plan.

7. Commutateur de colonne de direction selon au moins l'une des revendications précédentes, **caractérisé en ce que** les porteurs de charges (22 à 28, 122 à 129) sont disposés en angle, notamment perpendiculairement les uns par rapport aux autres.

8. Commutateur de colonne de direction selon au moins l'une des revendications précédentes, **caractérisé en ce que** sont prévus huit porteurs de charges (122 à 129) qui entourent le composant (34, 134) en formant une structure en cadre.

9. Commutateur de colonne de direction selon la revendication 8, **caractérisé en ce que** plusieurs structures en cadre parallèles les unes aux autres sont prévues.

10. Commutateur de colonne de direction selon la revendication 8 ou 9, **caractérisé en ce que** la structure en cadre présente un blindage.

11. Commutateur de colonne de direction selon au moins l'une des revendications précédentes, **caractérisé en ce que** le composant (34, 134) est réalisé sous la forme d'un coulisseau.

12. Commutateur de colonne de direction selon au moins l'une des revendications précédentes, **caractérisé en ce que** le composant (34, 134), pour modifier le champ électrique (30, 32, 130 à 133), présente des éléments de codage géométriques (138) qui sont respectivement formés par un élargissement du matériau.

13. Commutateur de colonne de direction selon au moins l'une des revendications précédentes, **caractérisé en ce que** le composant (34, 134) présente au moins dans certaines sections un matériau magnétique ou magnétisable.

14. Commutateur de colonne de direction selon au moins l'une des revendications précédentes, **caractérisé en ce que** le dispositif présente des moyens à cran d'arrêt pour le guidage forcé du moyen de commutation.

15. Commutateur de colonne de direction selon au moins l'une des revendications précédentes, **caractérisé en ce que** le dispositif présente un étui de protection (142).

16. Commutateur de colonne de direction selon la revendication 15, **caractérisé en ce que** la surface extérieure de l'étui de protection est adaptée à un espace d'accueil formé sur ou dans le moyen de commutation.

17. Commutateur de colonne de direction selon au moins l'une des revendications précédentes, **caractérisé en ce que** le dispositif comprend une unité de commande et/ou d'interprétation (10, 110) qui est en liaison avec les porteurs de charges (22 à 28, 122 à 129).

18. Commutateur de colonne de direction selon au moins l'une des revendications précédentes, **caractérisé en ce que** l'interprétation des signaux électriques générés par les porteurs de charges (22 à 28, 122 à 129) s'effectue en se basant sur des valeurs concrètes de la tension.

19. Commutateur de colonne de direction selon au moins l'une des revendications 1 à 17, **caractérisé en ce que** l'interprétation des signaux électriques générés par les porteurs de charges (22 à 28, 122 à 129) s'effectue en se basant sur des valeurs numérisées de la tension.

20. Commutateur de colonne de direction selon au moins l'une des revendications précédentes, **carac-**

**térisé en ce que** le dispositif présente en plus des éléments de Ci sensibles à la capacité.

EP 1 767 400 B1

Fig. 1

Fig. 2

Fig. 3

9

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4305007 A
- US 5479191 A
- DE 29817668 U1
- DE 10212824 A1